# EUROPÄISCHE PATENTSCHRIFT

(11) **EP 0 468 275 B1**
(45) Veröffentlichungstag und Bekanntmachung des Hinweises auf die Patenterteilung: **12.06.1996**
(21) Anmeldenummer: 91111416.3
(22) Anmeldetag: 09.07.1991
(51) Int. Cl.: H01L 23/498

(54) **Filmträger zur bandautomatischen Verdrahtung**
Filmcarrier for tape automated bonding
Support à film pour montage automatique sur bande

(30) Priorität: 23.07.1990 DE 4023385
(43) Veröffentlichungstag der Anmeldung: 29.01.1992
(73) Patentinhaber: Siemens Nixdorf Informationssysteme Aktiengesellschaft, D-33102 Paderborn (DE)
(72) Erfinder: Seidel, Wolfgang, Dipl-Ing., W-8000 München 21 (DE)
(74) Vertreter: Fuchs, Franz-Josef, Dr.-Ing.

(56) Entgegenhaltungen:
- EP-A- 0 103 888
- EP-A- 0 438 742
- DE-A- 3 809 005
- PATENT ABSTRACTS OF JAPAN vol. 014, no. 365 (E-0961)8. August 1990 & JP-A-02 129 941
- PATENT ABSTRACTS OF JAPAN vol. 010, no. 117 (E-400)2. Mai 1986 & JP-A-60 253 252
- PATENT ABSTRACTS OF JAPAN vol. 010, no. 268 (E-436)12. September 1986 JP-A-61 090 453

## Beschreibung

Die Erfindung betrifft eine geätzte Verdrahtung (Spider) für integrierte Schaltkreise, insbesondere filmmontierte integrierte Schaltkreise, mit einem an der Peripherie rundum verlaufenden an mehreren Punkten mit der Verdrahtung verbundenen metallischen Rahmen für Galvanisier- und Kurzschlußzwecke.

Um geätzte Verdrahtungen, wie z.B. Spider der Filmmontage, bei bandautomatischer Bonding-Technik galvanisch vergolden zu können, wird ein Kathodenanschluß in Form eines Galvanikrahmens benötigt. Dieser Rahmen, der gleichzeitig einen Kurzschluß für alle Leitungen bedeutet, muß nach der Herstellung der gedruckten Schaltung wieder aufgetrennt werden.

Ein solcher Rahmen ist beispielsweise aus der deutschen Patentschrift 32 34 745 bekannt, wo er vor allem als Kurzschlußrahmen zur Vermeidung elektrostatischer Aufladung während des Transports filmmontierter integrierter Schaltkreise dient. Das Trennen derartiger Rahmen von den geätzten Verdrahtungen, wie z.B. Spidern der Filmmontage, erfolgt nach dem Vergolden in der Weise, daß zwischen jeweils zwei Schaltkreisen ein Teil des Film-bandes von der Länge einer Transportperforationsteilung, die etwa 4 mm beträgt, weggeschnitten und verworfen wird. Damit wird aber ein Materialanteil von 10 % der Fläche des Trägermaterials, wie z.B. des Films, weggeworfen.

Aufgabe der vorliegenden Erfindung ist es daher, bei der geätzten Verdrahtung (Spider) für integrierte Schaltkreise den Verwurf von Trägermaterial zu verringern.

Zur Lösung dieser Aufgabe wird, wie im Patentanspruch definiert, der Rahmen für Galvanisier- und Kurzschlußzwecke bei geätzten Verdrahtungen für integrierte Schaltkreise derart ausgebildet, daß die Zuleitungen zu den Verbindungspunkten des Rahmens mit der Verdrahtung benachbarter Schaltkreise mäanderförmig ausgebildet sind.

Durch diese Maßnahmen lassen sich die benachbarten integrierten Schaltkreise ohne Materialverschnitt trennen. Dabei ist der Mäander so als Zuleitung zu den Schaltungen ausgelegt, daß mit einem Schnitt sämtliche Kurzschlußverbindungen aufgetrennt werden können.

Anhand des Ausführungsbeispiels nach der FIG wird die Erfindung näher erläutert. Die FIG zeigt mehrere nebeneinander auf einem Filmstreifen 3 angeordnete geätzte Verdrahtungen 4, wobei die Leiterbahnen der geätzten Verdrahtung sich im Zentrum der Verdrahtung an der Stelle treffen, wo später nach dem Ausschneiden des metallisierten Fleckes 5 die integrierte Schaltung eingesetzt wird. Der Galvanikrahmen besteht aus den Zuleitungen 1 zu den Verbindungspunkten 2 mit der geätzten Verdrahtung, sowie dem metallisierten Perforationsstreifen 6 beidseitig der geätzten Verdrahtungen. Die Zuleitungen 1, die zwischen den geätzten Verdrahtungen liegen, sind dabei an verschiedenen Stellen mäanderförmig derart ausgebildet, daß mit einem Schnitt die geätzten Verdrahtungen von den Zuleitungen an der Schnittlinie 7 getrennt werden können.

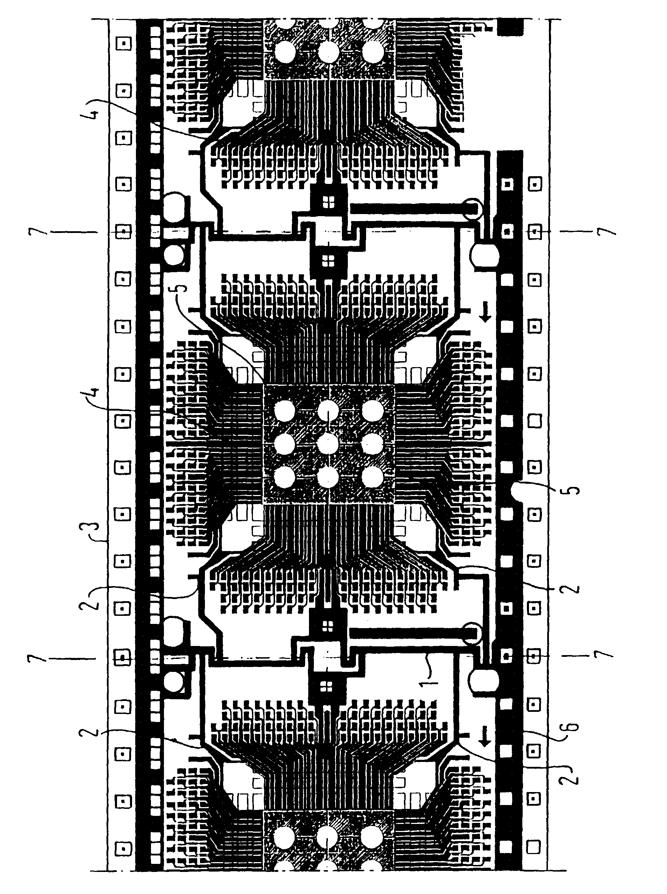

## Patentansprüche

1. Filmträger zur bandautomatischen Verdrahtung integrierter Schaltkreise mit einer Mehrzahl entlang eines Filmstreifens (3) benachbart angeordneter, geätzter Verdrahtungen (4), welche jeweils um ein einen integrierten Schaltkreis aufnehmendes Zentrum angeordnete Leiterbahnen sowie einen peripher um die Leiterbahnen verlaufenden und mit den Leiterbahnen an mehreren Verbindungspunkten (2) für Galvanisier- und Kurzschlußzwecke über Zuleitungen (1) verbundenen metallischen Rahmen (6) aufweisen,
**dadurch gekennzeichnet**, daß die Zuleitungen benachbarten Verdrahtungen gemeinsame Abschnitte aufweisen, welche entlang einer Schnittlinie (7) zwischen den benachbarten Verdrahtungen angeordnet sind und diese Schnittlinie mäanderförmig derart kreuzen, daß mit einem Schnitt sämtliche Kurzschlußverbindungen der Leiterbahnen aufgetrennt werden können.

## Claims

1. Film carrier for tape-automated bonded wiring of integrated circuits, with a plurality of etched bonded wirings (4), which are arranged adjacently along a film strip (3) and respectively have interconnections arranged around a centre that receives an integrated circuit as well as a metallic frame (6), extending peripherally around the interconnections and connected to the interconnections at a plurality of connection points (2) for electrodeposition and short-circuit purposes via leads (1), characterized in that the bonded wirings neighbouring the leads have common sections which are arranged along a section line (7) between the neighbouring bonded wirings and cross this section line in meander fashion in such a way that all short-circuit connections of the interconnections can be separated by a single cut.

## Revendications

1. Support de film pour le câblage automatique sur bande de circuits intégrés comportant une pluralité de câblages (4) qui sont formés par attaque chimique, qui sont disposés l'un à côté de l'autre le long d'une bande (3) de film et qui comportent chacun des pistes conductrices disposées autour d'un centre recevant un circuit intégré, ainsi qu'un cadre (6) métallique s'étendant périphériquement autour des pistes conductrices et relié aux pistes conductrices en plusieurs points (2) de liaison à des fins de galvanisation et de mise en court-circuit par l'intermédiaire de conducteurs (1) d'alimentation,
caractérisé en ce que les conducteurs d'alimentation de câblages voisins comportent des tronçons communs, qui sont disposés le long d'une ligne (7) d'intersection entre les câblages voisins et qui coupent cette ligne d'intersection de manière sinueuse de telle sorte que toutes les liaisons de court-circuit des pistes conductrices puissent être séparées par une coupure.
